(19) Europäisches Patentamt
European Patent Office
Office européen des brevets

(11) EP 4 184 564 A1

(12) **EUROPEAN PATENT APPLICATION**
published in accordance with Art. 153(4) EPC

(43) Date of publication:
**24.05.2023 Bulletin 2023/21**

(21) Application number: **21843425.6**

(22) Date of filing: **11.05.2021**

(51) International Patent Classification (IPC):
***H01L 23/373*** *(2006.01)* ***C08L 83/04*** *(2006.01)*
***C08K 3/22*** *(2006.01)* ***C08K 3/28*** *(2006.01)*

(52) Cooperative Patent Classification (CPC):
**C08K 3/22; C08K 3/28; C08L 83/04; H01L 23/373**

(86) International application number:
**PCT/JP2021/017796**

(87) International publication number:
**WO 2022/014129 (20.01.2022 Gazette 2022/03)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.07.2020 JP 2020121569**

(71) Applicant: **Resonac Corporation**
**Tokyo (JP)**

(72) Inventors:
- **YUKUTAKE, Hajime**
  **Yokohama-shi, Kanagawa 221-8517 (JP)**
- **MINORIKAWA, Naoki**
  **Yokohama-shi, Kanagawa 221-8517 (JP)**
- **FUNAHASHI, Hajime**
  **Yokohama-shi, Kanagawa 221-8517 (JP)**

(74) Representative: **Strehl Schübel-Hopf & Partner**
**Maximilianstrasse 54**
**80538 München (DE)**

(54) **THERMALLY CONDUCTIVE COMPOSITION AND CURED PRODUCT THEREOF**

(57) Provided is a thermally conductive composition containing a liquid resin, a thermally conductive powder, and a dispersant, in which the liquid resin has a viscosity of 10 mPa·s or more and 2,000 mPa·s or less at 25°C, the dispersant is an acrylic silicone, and at least one of the liquid resin and the thermally conductive powder contains an alkyl group having 4 or more carbon atoms.

EP 4 184 564 A1

## Description

Technical Field

The present invention relates to a thermally conductive composition and a cured product thereof.

Background Art

In recent years, with the development of high-performance and compact electronic apparatuses and components, the amount of heat generated by the electronic apparatus or the like becomes large, and a technique for releasing heat effectively has been actively studied. In particular, in order to effectively release heat from a heat generation source to a heat sink, high thermal conductivity and high insulation property are required for a thermally conductive material interposed between the heat generation source and the heat sink. In general, the thermally conductive material is made of a composition in which a matrix such as a resin is filled with a powder for imparting thermal conductivity. A metal oxide such as alumina and a metal nitride such as aluminum nitride can be used as the powder having thermal conductivity, and various dispersants and surface treatment agents have been studied in order to highly fill a resin matrix with these powders.

For example, PTL 1 discloses a thermally conductive silicone rubber composition obtained by dispersing, in a silicone rubber, a thermally conductive inorganic filler subjected to a surface treatment with a specific silane coupling agent containing an alkyl group. In addition, PTL 2 discloses a silicone resin composition containing a thermosetting silicone resin, an inorganic filler, and a dispersant having a specific structure.

Citation List

Patent Literature

PTL 1: JP 11-209618 A
PTL 2: WO 2017/002474

Summary of Invention

Technical Problem

In order to obtain a resin composition having high thermal conductivity by highly filling a resin with a powder having thermal conductivity, a large number of examples of using a silane coupling agent and a dispersant having a siloxane structure are reported as disclosed in PTLs 1 and 2. However, when an attempt is made to prepare a composition having higher thermal conductivity, there is a problem that flexibility of the composition is lost or it is difficult to coat a substrate with the composition.

The present invention is made to solve the above problem, and an object thereof is to provide a thermally conductive composition having excellent flexibility and excellent thermal conductivity.

Solution to Problem

As a result of intensive studies to solve the above problem, the present inventors have found that the above problem can be solved by the following invention.

That is, the invention relates to the following.

[1] A thermally conductive composition containing a liquid resin, a thermally conductive powder, and a dispersant, in which the liquid resin has a viscosity of 10 mPa·s or more and 2,000 mPa·s or less at 25°C, the dispersant is an acrylic silicone, and at least one of the liquid resin and the thermally conductive powder contains an alkyl group having 4 or more carbon atoms.

[2] The thermally conductive composition according to [1] above, in which the liquid resin is a silicone resin.

[3] The thermally conductive composition according to [2] above, in which the silicone resin is an alkyl-modified silicone oil.

[4] The thermally conductive composition according to any one of [1] to [3] above, in which the thermally conductive powder contains a metal nitride and a metal oxide.

[5] The thermally conductive composition according to [4] above, in which the metal oxide is alumina.

[6] The thermally conductive composition according to [4] above, in which the metal nitride is aluminum nitride, and the aluminum nitride has a silicon-containing oxide coating on a surface thereof.

[7] The thermally conductive composition according to any one of [1] to [6] above, in which with respect to a total amount of the thermally conductive composition, a content of the liquid resin is 1.0% by mass or more and 20.0% by mass or less, a content of the thermally conductive powder is 75.0% by mass or more and 98.0% by mass or less, and a content of the acrylic silicone is 0.1% by mass or more and 2.0% by mass or less.

[8] The thermally conductive composition according to any one of [1] to [7] above, in which a content ratio of the liquid resin to the acrylic silicone [liquid resin/acrylic silicone] is 85/15 to 98/2 in terms of a mass ratio.

[9] A cured product of the thermally conductive composition according to any one of [1] to [8] above.

Advantageous Effects of Invention

According to the present invention, a thermally conductive composition having excellent flexibility and excellent thermal conductivity can be provided.

Description of Embodiments

Hereinafter, the present invention will be described in detail with reference to an embodiment.

<Thermally Conductive Composition>

A thermally conductive composition according to the present embodiment contains a liquid resin, a thermally conductive powder, and a dispersant, the liquid resin has a viscosity of 10 mPa·s or more and 2,000 mPa·s or less at 25°C, the dispersant is an acrylic silicone, and at least one of the liquid resin and the thermally conductive powder contains an alkyl group having 4 or more carbon atoms. Accordingly, a thermally conductive composition having excellent flexibility and excellent thermal conductivity can be obtained.

(Liquid Resin)

The liquid resin used in the present embodiment has a viscosity of 10 mPa·s or more and 2,000 mPa·s or less at 25°C. Here, the liquid resin means a resin in a liquid form or having flowability at room temperature (25°C).

When the viscosity is 10 mPa·s or more, the liquid resin is excellent in thermal stability, and when the viscosity is 2,000 mPa·s or less, the thermally conductive powder can be highly filled. From such a viewpoint, the viscosity is preferably 20 mPa·s or more and 1,000 mPa·s or less, more preferably 20 mPa·s or more and 600 mPa·s or less, still more preferably 30 mPa·s or more and 400 mPa·s or less, and even still more preferably 30 mPa·s or more and 200 mPa·s or less.

The viscosity of the liquid resin at 25°C can be measured using a rotational viscometer (for example, trade name: TVB-10, rotor No. 3, manufactured by Toki Sangyo Co., Ltd.) under a condition of a rotational speed of 20 rpm in accordance with JIS Z8803:2011.

When the thermally conductive powder to be described later does not contain an alkyl group having 4 or more carbon atoms, the liquid resin contains an alkyl group having 4 or more carbon atoms from the viewpoint of increasing flexibility. The number of carbon atoms in the alkyl group contained in the liquid resin is preferably 6 or more, and more preferably 8 or more from the viewpoint of increasing flexibility. An upper limit of the number of carbon atoms is preferably 30, and more preferably 18. When the thermally conductive powder contains an alkyl group having 4 or more carbon atoms, the liquid resin may or may not contain an alkyl group having 4 or more carbon atoms.

The liquid resin is not particularly limited as long as the viscosity at 25°C is within the above range, and examples of the liquid resin include a silicone resin (excluding an acrylic silicone to be described later), an epoxy resin, an acrylic resin, a urethane resin, a phenol resin, a melamine resin, a urea resin, an unsaturated polyester, a fluororesin, a polyimide, a polyamide, and a polyester. Among these, a silicone resin is preferable from the viewpoint of having excellent heat resistance and excellent cold resistance and being usable in a wide temperature range. These resins may be used alone or in combination of two or more kinds thereof.

The silicone resin is not particularly limited, and examples of the silicone resin include a resin having an organopolysiloxane structure as a main chain, for example, a curable silicone resin and a non-curable silicone resin. Examples of the curable silicone resin include an addition reaction-curable silicone resin, a condensation reaction-curable silicone resin, and an organic peroxide-curable silicone resin, and an addition reaction-curable silicone resin is preferable from the viewpoint of increasing flexibility. A curable silicone resin filled with the thermally conductive powder can be used as a heat release sheet and a heat release gel. The non-curable silicone resin refers to an organopolysiloxane

whose base polymer does not contain a curable functional group such as an alkenyl group, and is also called a non-reactive silicone oil. The most common non-curable silicone resin is a dimethyl silicone oil, and a non-curable silicone resin filled with the thermally conductive powder can be used as a heat release grease and a heat release putty.

In the description, the silicone oil refers to a silicone resin that has a relatively low degree of polymerization among silicone resins and that is oily at normal temperature (25°C).

The silicone resin may contain a functional group other than the curable functional group represented by an alkenyl group. When the thermally conductive powder to be described later contains an alkyl group having 4 or more carbon atoms, for example, a methyl phenyl silicone resin and a phenyl silicone resin can be used as the silicone resin. The silicone resin may contain an alkyl group having 4 or more carbon atoms, or may be an alkyl-modified silicone oil from the viewpoint of increasing flexibility. Here, the alkyl-modified silicone oil means a silicone oil in which a portion of a methyl group in the dimethyl silicone oil is substituted with an alkyl group having 4 or more carbon atoms. The number of carbon atoms in the alkyl group is preferably 6 or more, and more preferably 8 or more from the viewpoint of increasing flexibility. The upper limit of the number of carbon atoms is preferably 30, and more preferably 18.

In addition, the alkyl-modified silicone oil may contain a curable functional group.

A commercial product of the silicone resin is available. Examples of a commercial product of the curable silicone resin include DOWSIL™ EG-3100 (manufactured by Dow Toray Co., Ltd.). For the non-curable silicone resin, examples of a commercial product of the dimethyl silicone oil include KF-96-100cs (manufactured by Shin-Etsu Chemical Co., Ltd.) and ELEMENT 14PDMS 100-J (manufactured by Momentive Performance Materials Japan LLC), and examples of a commercial product of the alkyl-modified silicone oil include KF-4003 (manufactured by Shin-Etsu Chemical Co., Ltd.) and X-22-7322 (manufactured by Shin-Etsu Chemical Co., Ltd.).

A content of the liquid resin is preferably 1.0% by mass or more and 20.0% by mass or less, and more preferably 2.0% by mass or more and 10.0% by mass or less with respect to the total amount of the thermally conductive composition according to the present embodiment. When the content of the liquid resin is 1.0% by mass or more, the thermally conductive powder can be kneaded with the liquid resin, and when the content of the liquid resin is 20.0% by mass or less, it is possible to impart the thermal conductivity that enables a use as a thermal conductive material.

(Thermally Conductive Powder)

The thermally conductive powder used in the present embodiment is a powder having a function of transferring heat generated from an electronic component or the like to the outside of the system, and examples thereof include a metal, a metal nitride, a metal oxide, a metal carbide, and a metal hydroxide. The thermally conductive powder may be used alone or in combination of two or more kinds thereof.

From the viewpoint of high thermal conductivity and high insulation property, the thermally conductive powder is preferably a metal nitride or a metal oxide, and particularly preferably consists of a metal nitride and a metal oxide.

Examples of the metal nitride include boron nitride, aluminum nitride, and silicon nitride. Among these, aluminum nitride is preferable from the viewpoint that the thermal conductivity is high and a filling property into a resin is high.

Examples of the metal oxide include zinc oxide, alumina, magnesium oxide, silicon dioxide, and iron oxide. Among these, alumina is preferable from the viewpoint that the thermal conductivity is high, a variety of particle sizes are lined up, and a degree of freedom in combination with the metal nitride is high.

When the liquid resin does not contain an alkyl group having 4 or more carbon atoms, the thermally conductive powder contains an alkyl group having 4 or more carbon atoms from the viewpoint of increasing flexibility. The number of carbon atoms in the alkyl group contained in the thermally conductive powder is preferably 6 or more, and more preferably 8 or more from the viewpoint of increasing flexibility. The upper limit of the number of carbon atoms is preferably 20, and more preferably 16.

A method of introducing the alkyl group having 4 or more carbon atoms into the thermally conductive powder can be appropriately selected depending on the type of the thermally conductive powder or the like. For example, when the thermally conductive powder is a metal oxide, the alkyl group having 4 or more carbon atoms can be introduced into a surface of the metal oxide by using a coupling agent.

A particle diameter at a cumulative volume of 50% of the thermally conductive powder (hereinafter, referred to as D50) in a particle size distribution obtained by a laser diffraction scattering method is preferably 0.2 pm or more and 200 pm or less, more preferably 0.5 pm or more and 100 pm or less, and still more preferably 1.0 pm or more and 50 pm or less from the viewpoint of a thickness adjustment of the thermal conductive material and a handling property when kneading the thermally conductive powder to the liquid resin.

The D50 of the thermally conductive powder can be measured by a particle size analyzer, and can be specifically measured by a method described in Examples.

[Aluminum Nitride]

A known material such as a commercial product can be used as aluminum nitride. Aluminum nitride may be obtained by any method, and may be obtained by, for example, a direct nitriding method in which a metal aluminum powder is directly reacted with nitrogen or ammonia, or a reduction nitriding method in which alumina is heated in a nitrogen or ammonia atmosphere while being carbon-reduced and a nitriding reaction is simultaneously performed.

A shape of aluminum nitride is not particularly limited, and examples of the shape include an amorphous shape (crushed shape), a spherical shape, an elliptical shape, and a plate shape (scale shape).

Further, the particle diameter (D50) at the cumulative volume of 50% of aluminum nitride in the particle size distribution obtained by the laser diffraction scattering method is preferably 0.2 pm or more and 200 pm or less, more preferably 10 pm or more and 100 pm or less, and still more preferably 10 pm or more and 50 pm or less.

From the viewpoint of improving moisture resistance, aluminum nitride preferably has a silicon-containing oxide coating on a surface thereof. The silicon-containing oxide coating may cover a part of the surface of aluminum nitride, or may cover the entire surface of aluminum nitride, and it is preferable to cover the entire surface of aluminum nitride.

Since aluminum nitride has excellent thermal conductivity, aluminum nitride having the silicon-containing oxide coating on the surface thereof (hereinafter, also referred to as "silicon-containing oxide coated aluminum nitride") also has excellent thermal conductivity.

Examples of the "silicon-containing oxide" in the silicon-containing oxide coating and particles of silicon-containing oxide coated aluminum nitride include silica, and an oxide containing silicon and aluminum.

In silicon-containing oxide coated aluminum nitride, a coverage ratio of the silicon-containing oxide coating covering the surface of aluminum nitride, which is obtained by LEIS analysis, is preferably 70% or more and 100% or less, more preferably 70% or more and 95% or less, still more preferably 72% or more and 90% or less, and particularly preferably 74% or more and 85% or less. When the coverage ratio is 70% or more and 100% or less, the moisture resistance is more excellent. When the coverage ratio exceeds 95%, the heat conductivity may decrease.

The coverage ratio (%) of the silicon-containing oxide coating ($SiO_2$) covering the surface of aluminum nitride, which is obtained by the low energy ion scattering (LEIS) analysis, is obtained by the following formula.

$$(S_{Al}(AlN) - S_{Al}(AlN+SiO_2))/S_{Al}(AlN) \times 100$$

In the formula, $S_{Al}$ (AlN) is an area of an Al peak of aluminum nitride, and $S_{Al}$ (AlN + $SiO_2$) is an area of an Al peak of silicon-containing oxide coated aluminum nitride. The area of the Al peak can be obtained based on analysis by the low energy ion scattering (LEIS) which is a measurement method using an ion source and a rare gas as probes. The LEIS is an evaluation method that enables composition analysis of an uppermost surface by an analysis method using a rare gas of several keV as incident ions (reference document: The TRC News 201610-04 (October, 2016)).

Examples of a method of forming the silicon-containing oxide coating on the surface of aluminum nitride include a method that includes a first step of covering the surface of aluminum nitride with a siloxane compound having a structure represented by the following formula (1), and a second step of heating aluminum nitride covered with the siloxane compound at a temperature of 300°C or higher and 800°C or lower.

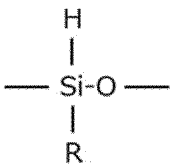

· · · (1)

In the formula (1), R is an alkyl group having 4 or less carbon atoms.

The structure represented by the formula (1) is a hydrogen siloxane structural unit having a Si-H bond. In the formula (1), R is an alkyl group having 4 or less carbon atoms, that is, a methyl group, an ethyl group, a propyl group or a butyl group, preferably a methyl group, an ethyl group, an isopropyl group or a t-butyl group, and more preferably a methyl group.

As the siloxane compound, an oligomer or polymer having the structure represented by the formula (1) as a repeating unit is preferable. Further, the siloxane compound may be linear, branched or cyclic. A weight average molecular weight of the siloxane compound is preferably 100 to 2,000, more preferably 150 to 1,000, and still more preferably 180 to 500 from the viewpoint of easy formation of the silicon-containing oxide coating having a uniform thickness. The weight average molecular weight is a value obtained by gel permeation chromatography (GPC) in terms of polystyrene.

As the siloxane compound, a compound represented by the following formula (2) and/or a compound represented by the following formula (3) is preferably used.

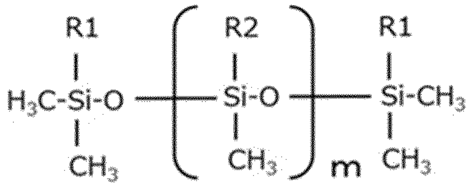

... (2)

In the formula (2), R1 and R2 each independently represents a hydrogen atom or a methyl group, and at least one of R1 and the R2 is a hydrogen atom. m is an integer of 0 to 10, preferably 1 to 5, and more preferably 1.

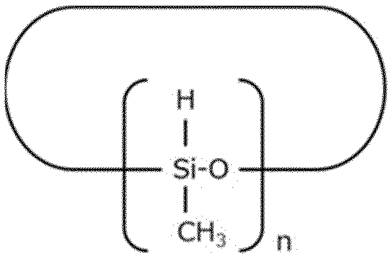

... (3)

In the formula (3), n is an integer of 3 to 6, preferably 3 to 5, and more preferably 4.
In particular, the siloxane compound is preferably a cyclic hydrogen siloxane oligomer with n being 4 in the formula (3) from the viewpoint of good easy formation of the silicon-containing oxide coating.
In the first step, the surface of aluminum nitride is covered with the siloxane compound having the structure represented by the formula (1).
In the first step, the method is not particularly limited as long as the surface of aluminum nitride can be covered with the siloxane compound having the structure represented by the formula (1). Examples of the method for the first step include a dry mixing method in which a general powder mixing device is used to add the siloxane compound by spraying or the like while stirring aluminum nitride as a raw material, and then dry mixing is performed to cover aluminum nitride.
Examples of the powder mixing device include such as a Henschel mixer (manufactured by NIPPON COKE & ENGINEERING. Co., Ltd.), a container rotation type V blender, and a double cone type blender, a ribbon blender provided with a mixing blade, a screw type blender, a sealed type rotary kiln, and stirring by a stirring bar in a sealed container using a magnet coupling. A temperature condition is not particularly limited, and is preferably 10°C or higher and 200°C or lower, more preferably 20°C or higher and 150°C or lower, and still more preferably 40°C or higher and 100°C or lower.
A vapor phase adsorption method may also be used in which a vapor of the siloxane compound alone or a mixed gas with an inert gas such as nitrogen gas is attached or deposited on the surface of aluminum nitride after standing. A temperature condition is not particularly limited, and is preferably 10°C or higher and 200°C or lower, more preferably 20°C or higher and 150°C or lower, still more preferably 40°C or higher and 100°C or lower. Further, if necessary, the inside of the system can be pressurized or depressurized. As a device that can be used in this case, a device which is a closed system and in which a gas in the closed system can be easily replaced is preferable, and for example, a glass container, a desiccator, or a CVD device can be used.
An amount of the siloxane compound used in the first step is not particularly limited. In aluminum nitride covered with the siloxane compound obtained in the first step, a coating amount of the siloxane compound is preferably 0.1 mg or more and 1.0 mg or less per 1 $m^2$ of a surface area calculated based on a specific surface area ($m^2/g$) of aluminum nitride obtained by a BET method, more preferably 0.2 mg or more and 0.8 mg or less, and still more preferably 0.3 mg or more and 0.6 mg or less. When the coating amount of the siloxane compound is within the above range, it is possible to obtain aluminum nitride having the silicon-containing oxide coating having a uniform thickness.
The coating amount of the siloxane compound per 1 $m^2$ of the surface area calculated based on the specific surface area ($m^2/g$) of aluminum nitride obtained by the BET method can be obtained by dividing a mass difference of aluminum nitride before and after coating with the siloxane compound by the surface area ($m^2$) calculated based on the specific surface area ($m^2/g$) of aluminum nitride obtained by the BET method.
The specific surface area obtained by the BET method can be measured by a nitrogen adsorption BET one-point method according to a gas flow method. As an evaluation device, Macsorb HM model-1210 manufactured by Mountech Co., Ltd. can be used.

In the second step, aluminum nitride covered with the siloxane compound obtained in the first step is heated at a temperature of 300°C or higher and 800°C or lower. Accordingly, the silicon-containing oxide coating can be formed on the surface of aluminum nitride. The heating temperature is more preferably 400°C or higher, and still more preferably 500°C or higher.

A heating time is preferably 30 minutes or longer and 6 hours or shorter, more preferably 45 minutes or longer and 4 hours or shorter, and still more preferably 1 hour or longer and 2 hours or shorter from the viewpoint of ensuring a sufficient reaction time and effectively forming a good silicon-containing oxide coating.

Regarding an atmosphere during the heat treatment, the heat treatment is preferably performed in an atmosphere containing an oxygen gas, for example, in atmosphere (in air).

After the heat treatment in the second step, the particles of silicon-containing oxide coated aluminum nitride may be partially fused to each other, and in such a case, the particles can be crushed using a general pulverizer such as a roller mill, a hammer mill, a jet mill, or a ball mill, to obtain silicon-containing oxide coated aluminum nitride having no sticking and agglomeration.

After the completion of the second step, the first step and the second step may be performed in order. That is, a step of sequentially performing the first step and the second step may be repeatedly executed.

[Alumina]

Alumina has thermal conductivity and is excellent in moisture resistance. Alumina is preferably α-alumina (α-$Al_2O_3$). Other than α-alumina, γ-alumina, θ-alumina, δ-alumina, and the like may be used.

A known material such as a commercial product can be used as the alumina. As known alumina such as a commercial product, optimal alumina having a wide variety of particle diameters and shapes, and being inexpensive can be selected.

Alumina may be obtained by any production method, and for example, alumina may be obtained by a thermal decomposition method of ammonium alum, a thermal decomposition method of ammonium aluminum carbonate, an underwater spark discharge method of aluminum, a vapor phase oxidation method, or a hydrolysis method of aluminum alkoxide.

A shape of alumina is not particularly limited, and examples thereof include an amorphous shape (crushed shape), a spherical shape, a rounded shape, and a polyhedral shape.

A particle size (D50) at the cumulative volume of 50% of alumina in the particle size distribution obtained by the laser diffraction scattering method is not particularly limited, and is preferably 0.1 pm or more and 50 pm or less.

For example, in the case of alumina, an alkyl group having 4 or more carbon atoms may be contained from the viewpoint of increasing flexibility. Examples of a method of introducing the alkyl group having 4 or more carbon atoms into alumina include a method of treating a surface of alumina with a silane coupling agent. The silane coupling agent is not particularly limited as long as the silane coupling agent contains an alkyl group having 4 or more carbon atoms, and examples thereof include butyltrimethoxysilane, hexyltrimethoxysilane, octyltrimethoxysilane, decyltrimethoxysilane, and hexadecyltrimethoxysilane. Among these, octyltrimethoxysilane, decyltrimethoxysilane, and hexadecyltrimethoxysilane are preferable, and decyltrimethoxysilane is more preferable from the viewpoint of increasing flexibility of the composition.

The silane coupling agent may be used alone or in combination of two or more kinds thereof.

An amount of the silane coupling agent used is preferably 0.01 parts by mass or more and 10 parts by mass or less, and more preferably 0.02 parts by mass or more and 5 parts by mass or less with respect to 100 parts by mass of the alumina. When the silane coupling agent is used in the above range, the surface treatment for alumina can be sufficiently performed.

As a representative method of treating alumina with the silane coupling agent, there is a method in which the silane coupling agent is added by spraying or the like while stirring alumina as the raw material by using a general powder mixing device, and then dry mixing is performed.

Examples of the powder mixing device include a Henschel mixer (manufactured by NIPPON COKE & ENGINEERING Co., Ltd.) and a Spartan Granulator (manufactured by Dalton Corporation).

In the treatment for alumina with the silane coupling agent, after mixing, the heat treatment is preferably performed at a temperature of 100°C to 140°C for 1 to 5 hours, and more preferably the heat treatment is performed at a temperature of 110°C to 130°C for 2 to 4 hours.

For example, when the thermally conductive powder is a mixture of aluminum nitride and alumina, a mass ratio of aluminum nitride to alumina [aluminum nitride/alumina] is preferably 20 to 80/80 to 20, and more preferably 30 to 70/70 to 30 from the viewpoint of increasing a filling property of the thermally conductive powder into the liquid resin.

The total content of aluminum nitride and alumina contained in the thermally conductive powder is preferably 90% by mass or more, more preferably 95% by mass or more, and particularly preferably 100% by mass from the viewpoint of increasing the thermal conductivity of the composition.

As the thermally conductive powder, powders having different particle diameters may be used. For example, by containing alumina having a small particle diameter (for example, D50 of 0.1 pm or more and 50 pm or less) and aluminum nitride having a particle diameter larger than that of alumina (for example, D50 of 10 pm or more and 100 pm or less), it is possible to increase an amount (% by mass) of the thermally conductive powder filled in the thermally conductive composition, and thus it is possible to further increase the heat conductivity of the thermally conductive composition.

The content of the thermally conductive powder is preferably 75.0% by mass or more and 98.0% by mass or less, and more preferably 85.0% by mass or more and 96.0% by mass or less with respect to the total amount of the thermally conductive composition according to the present embodiment. When the content of the thermally conductive powder is 75.0% by mass or more, the thermal conductivity of the composition can be improved, and when the content is 98.0% by mass or less, the thermally conductive powder can be kneaded with the liquid resin.

(Dispersant)

The dispersant used in the present embodiment is an acrylic silicone, and has a function of increasing the dispersibility of the thermally conductive powder. Examples of the acrylic silicone include a copolymer obtained by copolymerizing a (meth)acrylic acid ester having at least one polydimethylsiloxane structure [$-((CH_3)_2SiO)_p-$; p is an integer of 1 or more], and an alkyl (meth)acrylate as monomers. Here, the (meth)acrylic acid ester means an acrylic acid ester or a methacrylic acid ester.

Specific examples of the (meth)acrylic acid ester include dimethicone methacrylate. Further, specific examples of the alkyl (meth)acrylate include methyl methacrylate, ethyl methacrylate, butyl methacrylate, ethylhexyl acrylate, and tridecyl acrylate.

The polydimethylsiloxane structure in the (meth)acrylic acid ester preferably has 3 to 100 silicon atoms, more preferably 3 to 50 silicon atoms, and still more preferably 3 to 30 silicon atoms. An alkyl chain in the alkyl (meth)acrylate preferably has 1 to 15 carbon atoms, more preferably 1 to 12 carbon atoms, and still more preferably 1 to 9 carbon atoms.

The acrylic silicone used in the present embodiment is not limited to a binary copolymer consisting of only these components, and may be a multicomponent copolymer obtained by copolymerizing three or more types of monomers selected from a monomer containing a vinyl group such as vinyl methyl ether (meth)acrylate, a monomer containing a carboxy group such as (meth)acrylic acid, and the like. For example, a type of an alkyl group in an ester residue, a type of an alkyl group containing a siloxane moiety, and an acrylate and a methacrylate may be optionally used in combination of a plurality of types for polymerization.

Specific examples of the acrylic silicone include SYMAC (registered trademark) US-350 manufactured by Toagosei Co., Ltd., and KP-541, KP-574, and KP-578 manufactured by Shin-Etsu Chemical Co., Ltd.

A molecular weight of the acrylic silicone is not particularly limited, and a weight average molecular weight obtained by gel permeation chromatography (GPC) in terms of polystyrene is preferably 10,000 or more and 300,000 or less, more preferably 50,000 or more and 250,000 or less, and still more preferably 100,000 or more and 200,000 or less. When the weight average molecular weight is 10,000 or more, the dispersibility of the thermally conductive powder into the liquid resin can be increased, and when the weight average molecular weight is 300,000 or less, the viscosity decreases and the kneading is easier.

When the acrylic silicone also contains a monomer unit containing a carboxy group, an acid value thereof is preferably 3 mgKOH/g or more and 95 mgKOH/g or less, more preferably 3 mgKOH/g or more and 70 mgKOH/g or less, and still more preferably 3 mgKOH/g or more and 50 mgKOH/g or less. When the acid value of the acrylic silicone is within the above range, the thermally conductive powder can be easily dispersed into the liquid resin.

The acid value can be measured in accordance with JIS K2501:2003. Specifically, the acid value can be obtained by preparing a sample ethanol solution having a concentration of 5 g/L and performing potentiometric titration using a 2-propanol solution of potassium hydroxide having a concentration of 0.1 mol/L. When the acrylic silicone does not contain a carboxy group, the acid value is substantially 0 mgKOH/g.

When the acrylic silicone also contains a monomer unit having a polyalkoxysilyl structure, the number of moles of the polyalkoxysilyl structure is preferably 3 mol to 30 mol, more preferably 3 mol to 20 mol, and still more preferably 5 mol to 15 mol per molecule of the acrylic silicone from the viewpoint of the viscosity and the dispersibility.

The number of moles of the polyalkoxysilyl structure can be calculated by combining GPC with nuclear magnetic resonance (NMR) of $^{1}H$, $^{13}C$, and $^{29}Si$.

A method of polymerizing the monomer when synthesizing the acrylic silicone is not particularly limited, and living anionic polymerization or living radical polymerization is preferable from the viewpoint that a degree of polymerization can easily be controlled. These polymerization methods are polymerization methods in which an active species of growth is a stable anion or radical, since the active species is stable, a growing end is stable even after the monomer is consumed, and when the monomer is added, the polymerization is restarted, and thus there is an advantage that the degree of polymerization can be easily controlled.

The viscosity of the acrylic silicone at 25°C is preferably 10 mPa·s or more and 2,000 mPa·s or less, and more preferably 20 mPa·s or more and 1,000 mPa·s or less from the viewpoint of ensuring flowability at a level same as that of the liquid resin.

The viscosity of the acrylic silicone at 25°C can be measured using a rotational viscometer (for example, trade name: TVB-10, rotor No. 3, manufactured by Toki Sangyo Co., Ltd.) under a condition of a rotational speed of 20 rpm in accordance with JIS Z8803:2011.

A content ratio of the liquid resin to the acrylic silicone [liquid resin/acrylic silicone] is preferably 85/15 to 98/2, and more preferably 88/12 to 94/6 in terms of a mass ratio. When the content ratio is 85/15 or more, a decrease in heat resistance can be prevented, and when the content ratio is 98/2 or less, the liquid resin can be highly filled with the thermally conductive powder.

The content of the acrylic silicone is preferably 0.1% by mass or more and 2.0% by mass or less, and more preferably 0.2% by mass or more and 1.0% by mass or less with respect to the total amount of the thermally conductive composition according to the present embodiment. When the content of the acrylic silicone is 0.1% by mass or more, the dispersibility of the thermally conductive powder can be increased, and when the content of the acrylic silicone is 2.0% by mass or less, a volatile content at a high temperature can be reduced.

In addition to the components described above, the thermally conductive composition according to the present embodiment may contain additives such as a flexibility imparting agent, an inorganic ion scavenger, a pigment, a dye, a diluent, and a reaction accelerator as necessary as long as effects of the present invention are not impaired.

In the thermally conductive composition according to the present embodiment, the total content of the liquid resin, the thermally conductive powder, and the acrylic silicone is preferably 80 to 100% by mass, more preferably 90 to 100% by mass, and still more preferably 95 to 100% by mass.

The content of the liquid resin is preferably 1.0% by mass or more and 20.0% by mass or less with respect to the total amount of the thermally conductive composition according to the present embodiment, and within this range, the thermal conductivity can be further increased.

The content of the thermally conductive powder is preferably 75.0% by mass or more and 98.0% by mass or less with respect to the total amount of the thermally conductive composition according to the present embodiment. When the content of the thermally conductive powder is 75.0% by mass or more, the thermal conductivity of the composition can be further increased, and when the content of the thermally conductive powder is 98.0% by mass or less, the thermally conductive powder can be kneaded with the liquid resin.

The content of the acrylic silicone is preferably 0.1% by mass or more and 2.0% by mass or less with respect to the total amount of the thermally conductive composition according to the present embodiment. When the content of the acrylic silicone is 0.1% by mass or more, the dispersibility of the thermally conductive powder can be increased, and when the content of the acrylic silicone is 2.0% by mass or less, the volatile content at a high temperature can be reduced.

The thermally conductive composition according to the present embodiment can be obtained by collectively or separately supplying the liquid resin, the thermally conductive powder, the acrylic silicone, and various additives to be added as necessary to a device for dispersing and dissolving, and mixing, dissolving, and kneading these components while heating the components as necessary. Examples of the device for dispersing and dissolving include a stone mill, a planetary mixer, a rotation-revolution mixer, a kneader, and a roll mill.

A consistency of the thermally conductive composition according to the present embodiment is preferably 260 or more and 350 or less, and more preferably 265 or more and 340 or less.

In the present description, the consistency is an index indicating the flexibility of the thermally conductive composition, and indicates that the greater a value of the consistency, the flexible the thermally conductive composition. When the consistency of the thermally conductive composition is within the above range, the thermally conductive composition is excellent in flexibility.

The consistency can be measured by a method in accordance with JIS K2220:2013, and can be specifically measured by a method described in Examples.

The viscosity of the thermally conductive composition according to the present embodiment is preferably 100 Pa·s or more and 1,000 Pa·s or less, more preferably 150 Pa·s or more and 800 Pa·s or less, and still more preferably 200 Pa·s or more and 500 Pa·s or less.

The viscosity can be measured by a method in accordance with JIS K7210:2014 using a flow viscometer, and can be specifically measured by a method described in Examples.

The heat conductivity of the thermally conductive composition according to the present embodiment is preferably 4.0 W/m·K or more, more preferably 5.0 W/m·K or more, and still more preferably 6.0 W/m·K or more.

The heat conductivity can be measured by a hot disk method in accordance with ISO22007-2, and can be specifically measured by a method described in Examples.

Since the thermally conductive composition according to the present embodiment is excellent in flexibility and is excellent in thermal conductivity, the thermally conductive composition can be suitably used for a heat-generating electronic component such as an electronic apparatus, a personal computer, and an ECU and a battery for an automobile.

[Cured Product]

When the liquid resin is of a curable type, a cured product can be obtained by adding a crosslinking agent and a curing agent such as a metal catalyst to prepare the thermally conductive composition, and curing the thermally conductive composition at room temperature (25°C), by heating or moisture. For example, in a case of an addition reaction-curable silicone resin having a feature that the liquid resin is excellent in flexibility and adhesion among curable silicone resins and does not generate a by-product that may become a causative substance such as air bubbles, a silicone resin cured product can be obtained by preparing the thermally conductive composition using an organopolysiloxane containing an alkenyl group as a base polymer, an organopolysiloxane containing a Si-H group as a crosslinking agent, and a curing agent represented by a platinum catalyst, and reacting the thermally conductive composition at room temperature (25°C) or by heating. When the thermally conductive composition is cured by heating, the heating is preferably performed at a condition of a temperature of 50°C or higher and 150°C or lower for 5 minutes or longer and 2 hours or shorter, more preferably at a condition of a temperature of 60°C or higher and 120°C or lower for 10 minutes or longer and 1 hour or shorter. The cured product obtained in this manner is made of the above thermally conductive composition, and therefore is excellent in thermal conductivity.

From the viewpoint of flexibility, the cured product of the thermally conductive composition according to the present embodiment has an Asker C hardness of preferably 5 or more and 50 or less, more preferably 8 or more and 48 or less, and still more preferably 10 or more and 45 or less.

The Asker C hardness can be measured by a method in accordance with a hardness test (type C) according to JIS K7312:1996 using an Asker C hardness meter, and specifically, can be measured by a method described in Examples.

[Examples]

Next, the present invention will be specifically described with reference to Examples, but the present invention is not limited by these Examples in any way.

[Synthesis Example 1: Preparation of Silicon-containing Oxide Coated Aluminum Nitride]

In the first step, the surface of aluminum nitride was coated using a vacuum desiccator, which was made of an acrylic resin having a thickness of 20 mm, had an inner dimension of 260 mm × 260 mm × 100 mm, and had a structure divided into upper and lower parts by a partition with a through hole. In the upper part of the vacuum desiccator, 30 g of spherical aluminum nitride (FAN-f50-A1, manufactured by Furukawa Denshi Co., Ltd.) having D50 of 42 pm and a specific surface area of 0.08 $m^2/g$ obtained by the BET method was uniformly spread and left to stand on a stainless tray. Next, in the lower part of the vacuum desiccator, 10 g of a siloxane compound (cyclic methylhydrogensiloxane tetramer, manufactured by Tokyo Kasei Kogyo Co., Ltd.) with n = 4 in the formula (3) was charged into a glass petri dish and left to stand. Then, the vacuum desiccator was closed and was heated in an oven at 80°C for 30 hours. For a hydrogen gas generated by a reaction, a safety measure was taken to perform an operation, such as releasing the hydrogen gas from a release valve attached to the vacuum desiccator. After the completion of the first step, a sample taken out from the desiccator was charged into a crucible made of alumina, and the sample was subjected to a heat treatment in the second step under conditions of 650°C and 1.5 hours in atmosphere, thereby obtaining silicon-containing oxide coated aluminum nitride.

The specific surface area of aluminum nitride obtained by the BET method was measured using Macsorb HM model-1210 manufactured by Mountech Co., Ltd. As an adsorption gas, a mixed gas containing 70 vol% of He and 30 vol% of $N_2$ was used.

[Alumina Surface Treatment]

(1) Treatment 1: Alumina Surface-treated Product 1

1.0 g of KBM-3103C (decyltrimethoxysilane, manufactured by Shin-Etsu Chemical Co., Ltd., minimum coating area: 297 $m^2/g$) as a surface treatment agent was dissolved in 9.0 g of a solvent (ethanol/water = 9/1) to prepare a hydrolysis solution.

100 g of alumina AA-18 (manufactured by Sumitomo Chemical Co., Ltd., D50 = 20 pm, specific surface area: 0.15 $m^2/g$) was charged to a container, the hydrolysis solution corresponding to an amount of decyltrimethoxysilane calculated by the following equation (I) was added with a dropper, and then stirring and mixing at a rotational speed of 2,000 rpm for 20 seconds were repeated three times with a rotation-revolution mixer (ARE-310 manufactured by Thinky Corporation). The obtained mixture was charged into a stainless vat, and was subjected to a heat treatment at a temperature of 120°C for 2 hours in a hot air oven to obtain a surface-treated product of alumina AA-18 (alumina surface-treated product 1).

$$\text{AMOUNT OF SURFACE TREATMENT AGENT (g)} = \frac{\text{SPECIFIC SURFACE AREA OF ALUMINA (m}^2\text{/g)} \times \text{AMOUNT OF ALUMINA (g)}}{\text{MINIMUM COATING AREA OF SURFACE TREATMENT AGENT (m}^2\text{/g)}} \quad \text{(I)}$$

(2) Treatment 2: Alumina Surface-treated Product 2

1.0 g of KBM-3033 (propyltrimethoxysilane, manufactured by Shin-Etsu Chemical Co., Ltd., minimum coating area: 475 $m^2/g$) as a surface treatment agent was dissolved in 9.0 g of a solvent (ethanol/water = 9/1) to prepare a hydrolysis solution.

100 g of alumina AA-18 (manufactured by Sumitomo Chemical Co., Ltd., D50 = 20 pm, specific surface area: 0.15 $m^2/g$) was charged into a container, the hydrolysis solution corresponding to an amount of propyltrimethoxysilane calculated by the above equation (I) was added with a dropper, and then stirring and mixing at a rotational speed of 2,000 rpm for 20 seconds were repeated three times with a rotation-revolution mixer (manufactured by Thinky Corporation). The obtained mixture was charged into a stainless vat, and was subjected to a heat treatment at a temperature of 120°C for 2 hours in a hot air oven to obtain a surface-treated product of alumina AA-18 (alumina surface-treated product 2).

(3) Treatment 3: Alumina Surface-treated Product 3

A surface-treated product of alumina AA-5 (alumina surface-treated product 3) was obtained in the same manner as in Treatment 1, except that AA-5 (manufactured by Sumitomo Chemical Co., Ltd., D50 = 6 pm, specific surface area: 0.28 $m^2/g$) was used as alumina instead of AA-18, and the hydrolysis solution corresponding to an amount of decyltrimethoxysilane calculated by the above equation (I) was used.

(4) Treatment 4: Alumina Surface-treated Product 4

A surface-treated product of alumina AA-5 (alumina surface-treated product 4) was obtained in the same manner as in Treatment 2, except that AA-5 (manufactured by Sumitomo Chemical Co., Ltd., D50 = 6 pm, specific surface area: 0.28 $m^2/g$) was used as alumina instead of AA-18, and the hydrolysis solution corresponding to an amount of propyltrimethoxysilane calculated by the above equation (I) was used.

(5) Treatment 5: Alumina Surface-treated Product 5

4.0 g of KBM-3103C (decyltrimethoxysilane, manufactured by Shin-Etsu Chemical Co., Ltd., minimum coating area: 297 $m^2/g$) as a surface treatment agent was dissolved in 6.0 g of a solvent (ethanol/water = 9/1) to prepare a hydrolysis solution.

100 g of alumina AKP-20 (manufactured by Sumitomo Chemical Co., Ltd., D50 = 0.5 pm, specific surface area: 4.32 $m^2/g$) was charged into a container, the hydrolysis solution corresponding to an amount of decyltrimethoxysilane calculated by the above equation (I) was added with a dropper, and then stirring and mixing at a rotational speed of 2,000 rpm for 20 seconds were repeated three times with a rotation-revolution mixer (ARE-310 manufactured by Thinky Corporation). The obtained mixture was charged into a stainless vat, and was subjected to a heat treatment at a temperature of 120°C for 2 hours in a hot air oven to obtain a surface-treated product of alumina AKP-20 (alumina surface-treated product 5).

(6) Treatment 6: Alumina Surface-treated Product 6

4.0 g of KBM-3033 (propyltrimethoxysilane, manufactured by Shin-Etsu Chemical Co., Ltd., minimum coating area: 475 $m^2/g$) as a surface treatment agent was dissolved in 6.0 g of a solvent (ethanol/water = 9/1) to prepare a hydrolysis solution.

100 g of alumina AKP-20 (manufactured by Sumitomo Chemical Co., Ltd., D50 = 0.5 pm, specific surface area: 4.32 $m^2/g$) was charged into a container, the hydrolysis solution corresponding to an amount of propyltrimethoxysilane calculated by the above equation (I) was added with a dropper, and then stirring and mixing at a rotational speed of 2,000 rpm for 20 seconds were repeated three times with a rotation-revolution mixer (manufactured by Thinky Corporation). The obtained mixture was charged into a stainless vat, and was subjected to a heat treatment at a temperature

of 120°C for 2 hours in a hot air oven to obtain a surface-treated product of alumina AKP-20 (alumina surface-treated product 6).

(Examples 1 to 5 and Comparative Examples 1 to 9)

Respective components having types and amounts shown in Tables 1 and 2 were weighed into a polyethylene container, and were charged into a rotation-revolution mixer (manufactured by Thinky Corporation), and then stirring and mixing at a rotational speed of 2,000 rpm for 20 seconds were repeated three times to obtain thermally conductive compositions of respective Examples and Comparative Examples. Blanks in Tables 1 and 2 indicate no formulation.

(Examples 6 and 7 and Comparative Examples 10 to 15)

Respective components having types and amounts shown in Table 3 were weighed into a polyethylene container, and were charged into a rotation-revolution mixer (manufactured by Thinky Corporation), and then stirring and mixing at a rotational speed of 2,000 rpm for 20 seconds were repeated three times to obtain thermally conductive compositions of respective Examples and Comparative Examples. Blanks in Table 3 indicate no formulation.

The thermally conductive composition from which air bubbles were removed was placed on a polyester film having a thickness of 0.1 mm which was subjected to a silicone release treatment, a polyester film having a thickness of 0.1 mm was placed on the thermally conductive composition such that the thermally conductive composition was not mixed with air, and the obtained product was molded by a rolling roll, was cured at 100°C for 15 minutes, and further was left to stand at room temperature (23°C) for one day to obtain a sheet having a thickness of 2.0 mm.

Details of the respective components described in Tables 1 to 3 used in the preparation of the thermally conductive composition are as follows.

<Liquid Resin>

(Non-curable Silicone Resin)

·KF-96-100cs: dimethyl silicone oil, manufactured by Shin-Etsu Chemical Co., Ltd., viscosity (25°C) = 100 mPa.s
·KF-4003: alkyl-modified silicone oil (containing an alkyl group having 8 carbon atoms), manufactured by Shin-Etsu Chemical Co., Ltd., viscosity (25°C) = 40 mPa.s

(Curable Silicone Resin)

·DOWSIL™ EG-3100: vinyl group-containing dimethyl silicone resin (containing a crosslinking agent and a platinum catalyst), manufactured by Dow Toray Co., Ltd., viscosity (25°C) = 320 mPa s

<Dispersant>

·KP-578: acrylic silicone [(acrylate/ethylhexyl acrylate/dimethicone methacrylate) copolymer], manufactured by Shin-Etsu Chemical Co., Ltd., viscosity (25°C) = 180 mPa s

<Thermally Conductive Powder>

(Aluminum Nitride)

·FAN-f50-A1: manufactured by Furukawa Denshi Co., Ltd., D50 = 42 pm, specific surface area (by BET method) = 0.08 $m^2$/g
·FAN-f50-A1 silicon-containing oxide coating: silicon-containing oxide coated aluminum nitride produced in Synthesis Example 1, D50 = 45 pm

(Alumina)

·AA-18: manufactured by Sumitomo Chemical Co., Ltd., D50 = 20 pm
·Alumina surface-treated product 1: surface-treated product of AA-18 obtained in Treatment 1
·Alumina surface-treated product 2: surface-treated product of AA-18 obtained in Treatment 2
·AA-5: manufactured by Sumitomo Chemical Co., Ltd., D50 = 6 pm
·Alumina surface-treated product 3: surface-treated product of AA-5 obtained in Treatment 3
· Alumina surface-treated product 4: surface-treated product of AA-5 obtained in Treatment 4
·AKP-20: manufactured by Sumitomo Chemical Co., Ltd., D50 = 0.5 pm
·Alumina surface-treated product 5: surface-treated product of AKP-20 obtained in Treatment 5
·Alumina surface-treated product 6: surface-treated product of AKP-20 obtained in Treatment 6

<Other Components>

(Curing Catalyst)

·XC86-250: platinum catalyst, manufactured by Momentive Performance Materials

(Crosslinking Agent)

·TSF-484: hydrogen siloxane, manufactured by Momentive Performance Materials

The D50 of the thermally conductive powder was obtained based on the particle diameter (50% particle diameter D50) at which the cumulative volume was 50% in a particle size distribution measured using a laser diffraction type particle size distribution analyzer (trade name: MT3300EXII manufactured by MicrotracBEL Corp.).

<Evaluation Items>

(1) Consistency

The consistency was obtained by the following procedure in a 1/4 scale in accordance with JIS K2220:2013.

A thermally conductive composition was charged into a sample container made of brass, a surface of the thermally conductive composition was flattened, and then a 1/4 cone was dropped onto the thermally conductive composition at 25°C for 5 seconds, a penetration depth was measured, and the consistency was calculated based on the following equation.

$$\text{Consistency} = 3.75 \times (\text{penetration depth (mm)} \times 10) + 24$$

(2) Heat Conductivity

(Examples 1 to 5 and Comparative Examples 1 to 9)

Two sample containers made of brass similar to that for consistency measurement were prepared, into which the thermally conductive composition was charged, surfaces of the sample containers were covered with a wrap, the sample containers were set in a form of sandwiching from above and below a probe of a hot disk method-based measurement device (TPS-2500 manufactured by Kyoto Electronics Manufacturing Co., Ltd.) in accordance with ISO22007-2, and the heat conductivity was measured.

(Examples 6 and 7 and Comparative Examples 10 to 15)

The obtained sheet having a thickness of 2.0 mm was cut into a strip with a width of 20 mm and a length of 30

mm, two blocks each made by stacking three strips were prepared, surfaces of the blocks were covered with a wrap, the blocks were set in a form of sandwiching from above and below a probe of a hot disk method-based measurement device (TPS-2500 manufactured by Kyoto Electronics Manufacturing Co., Ltd.) in accordance with ISO22007-2, and the heat conductivity was measured.

(3) Flow Viscosity

In accordance with JIS K7210:2014, the flow viscosity was measured using a flow viscometer (GFT-100EX, manufactured by Shimadzu Corporation) under conditions of a temperature of 30°C, a die hole diameter of 1.0 mm, and a test force of 40 (weight of 7.8 kg).

(4) Asker C Hardness

The obtained sheet having a thickness of 2.0 mm was cut into a strip with a width of 20 mm and a length of 30 mm, and a block made by stacking three strips was prepared and was used as a measurement sample. An Asker C hardness of the measurement sample was measured in accordance with a hardness test (type C) in JIS K7312:1996 by using an Asker C hardness tester (Asker C rubber hardness tester, manufactured by Kobunshi Keiki Co., Ltd.).

[Table 1]

| | | | | Example 1 | Example 2 | Comparative Example 1 | Comparative Example 2 | Comparative Example 3 | Comparative Example 4 | Comparative Example 5 | Comparative Example 6 |
|---|---|---|---|---|---|---|---|---|---|---|---|
| Composition [% by mass] | Liquid resin | Dimethyl silicone oil | KF-96-100cs | 5.4 | 5.4 | 5.4 | 5.9 | 5.9 | 5.9 | 5.4 | 5.4 |
| | Dispersant | Acrylic silicone | KP-578 | 0.5 | 0.5 | 0.5 | | | | 0.5 | 0.5 |
| | Thermally conductive powder | Aluminum nitride | FAN-f50-A1 | 47.1 | | 47.1 | 47.1 | 47.1 | | 47.1 | |
| | | | FAN-f50-A1 silicon-containing oxide coating | | 47.1 | | | | 47.1 | | 47.1 |
| | | Alumina | AA-18 | | | 9.4 | 9.4 | | | | |
| | | | Alumina surface-treated product 1 | 9.4 | 9.4 | | | 9.4 | 9.4 | | |
| | | | Alumina surface-treated product 2 | | | | | | | 9.4 | 9.4 |
| | | | AA-5 | | | 18.8 | 18.8 | | | | |
| | | | Alumina surface-treated product 3 | 18.8 | 18.8 | | | 18.8 | 18.8 | | |
| | | | Alumina surface-treated product 4 | | | | | | | 18.8 | 18.8 |

(continued)

| | | | | Example 1 | Example 2 | Comparative Example 1 | Comparative Example 2 | Comparative Example 3 | Comparative Example 4 | Comparative Example 5 | Comparative Example 6 |
|---|---|---|---|---|---|---|---|---|---|---|---|
| | | | AKP-20 | | | 18.8 | 18.8 | | | | |
| | | | Alumina surface-treated product 5 | 18.8 | 18.8 | | | 18.8 | 18.8 | | |
| | | | Alumina surface-treated product 6 | | | | | | | 18.8 | 18.8 |
| Evaluation | Consistency | | | 275 | 271 | 238 | 205 | 218 | 219 | 226 | 234 |
| | Heat conductivity [W/m·K] | | | 6.8 | 6.7 | 7.1 | 7.3 | 6.8 | 6.8 | 6.7 | 6.8 |

[Table 2]

| | | | | Example 3 | Example 4 | Example 5 | Comparative Example 7 | Comparative Example 8 | Comparative Example 9 |
|---|---|---|---|---|---|---|---|---|---|
| Composition[% by mass] | Liquid resin | Alkyl-modified silicone oil | KF-4003 | 5.4 | 5.4 | 5.4 | 5.9 | 5.9 | 5.9 |
| | Dispersant | Acrylic silicone | KP-578 | 0.5 | 0.5 | 0.5 | | | |
| | Thermally conductive powder | Aluminum nitride | FAN-f50-A1 | 47.1 | 47.1 | | 47.1 | 47.1 | |
| | | | FAN-f50-A1 silicon-containing oxide coating | | | 47.1 | | | 47.1 |
| | | Alumina | AA-18 | 9.4 | | | 9.4 | | |
| | | | Alumina surface-treated product 1 | | 9.4 | 9.4 | | 9.4 | 9.4 |
| | | | AA-5 | 18.8 | | | 18.8 | | |
| | | | Alumina surface-treated product 3 | | 18.8 | 18.8 | | 18.8 | 18.8 |
| | | | AKP-20 | 18.8 | | | 18.8 | | |
| | | | Alumina surface-treated product 5 | | 18.8 | 18.8 | | 18.8 | 18.8 |
| Evaluation | Consistency | | | 294 | 295 | 292 | 259 | 257 | 254 |
| | Heat conductivity [W/m·K] | | | 6.9 | 6.4 | 6.3 | 6.9 | 6.5 | 6.4 |

According to Table 1 and Table 2, it can be seen that in all of Examples 1 to 5 using liquid resin with alkyl groups having 4 or more carbon atoms and/or alumina surface treated with decyltrimethoxysilane as thermally conductive powder, the consistency is as high as 270 or more and the heat conductivity is as high as 6.0 W/m·K or more.

[Table 3]

| | | | | Example 6 | Example 7 | Comparative Example 10 | Comparative Example 11 | Comparative Example 12 | Comparative Example 13 | Comparative Example 14 | Comparative Example 15 |
|---|---|---|---|---|---|---|---|---|---|---|---|
| Composition [% by mass] | Liquid resin | Vinyl group-containing dimethyl silicone resin | EG-3100 | 5.4 | 5.4 | 5.2 | 5.7 | 5.9 | 5.9 | 5.4 | 5.4 |
| | Curing catalyst | Platinum catalyst | XC86-250 | | | 0.1 | 0.1 | | | | |
| | Crosslinking agent | Hydrogen siloxane | TSF-484 | | | 0.1 | 0.1 | | | | |
| | Dispersant | Acrylic silicone | KP-578 | 0.5 | 0.5 | 0.5 | | | | 0.5 | 0.5 |
| | | Aluminum nitride | FAN-f50-A1 | 47.1 | | 47.1 | 47.1 | 47.1 | | 47.1 | |
| | | | FAN-f50-A1 silicon-containing oxide coating | | 47.1 | | | | 47.1 | | 47.1 |
| | | | AA-18 | | | 9.4 | 9.4 | | | | |
| | | | Alumina surface-treated product 1 | 9.4 | 9.4 | | | 9.4 | 9.4 | | |
| | | | Alumina surface-treated product 2 | | | | | | | 9.4 | 9.4 |

(continued)

| | | | | Example 6 | Example 7 | Comparative Example 10 | Comparative Example 11 | Comparative Example 12 | Comparative Example 13 | Comparative Example 14 | Comparative Example 15 |
|---|---|---|---|---|---|---|---|---|---|---|---|
| | Thermally conductive powder | Alumina | AA-5 | | | 18.8 | 18.8 | | | | |
| | | | Alumina surface-treated product 3 | 18.8 | 18.8 | | | 18.8 | 18.8 | | |
| | | | Alumina surface-treated product 4 | | | | | | | 18.8 | 18.8 |
| | | | AKP-20 | | | 18.8 | 18.8 | | | | |
| | | | Alumina surface-treated product 5 | 18.8 | 18.8 | | | 18.8 | 18.8 | | |
| | | | Alumina surface-treated product 6 | | | | | | | 18.8 | 18.8 |
| Evaluation | Viscosity [Pa·s] | | | 350 | 350 | 3020 | 9210 | 460 | 640 | 2850 | 4740 |
| | Asker C hardness [-] | | | 17 | 43 | 91 | 88 | 53 | 66 | 61 | 66 |
| | Heat conductivity [W/m·K] | | | 7.0 | 6.9 | 7.3 | 7.1 | 6.9 | 7.1 | 6.7 | 6.7 |

According to Table 3, it can be seen that in both of Examples 6 and 7 using liquid resin with alkyl groups having 4 or more carbon atoms and/or alumina surface treated with decyltrimethoxysilane as thermally conductive powder, the viscosity of the thermally conductive composition is as low as 350 Pa·s, the Asker C hardness of the cured product thereof is 50 or less with excellent flexibility, and the heat conductivity is as high as 6.0 W/m·K or more.

## Claims

1. A thermally conductive composition comprising:

   a liquid resin;
   a thermally conductive powder; and
   a dispersant, wherein
   the liquid resin has a viscosity of 10 mPa·s or more and 2,000 mPa·s or less at 25°C,
   the dispersant is an acrylic silicone, and
   at least one of the liquid resin and the thermally conductive powder contains an alkyl group having 4 or more carbon atoms.

2. The thermally conductive composition according to claim 1, wherein the liquid resin is a silicone resin.

3. The thermally conductive composition according to claim 2, wherein the silicone resin is an alkyl-modified silicone oil.

4. The thermally conductive composition according to any one of claims 1 to 3, wherein the thermally conductive powder contains a metal nitride and a metal oxide.

5. The thermally conductive composition according to claim 4, wherein the metal oxide is alumina.

6. The thermally conductive composition according to claim 4, wherein the metal nitride is aluminum nitride, and the aluminum nitride has a silicon-containing oxide coating on a surface thereof.

7. The thermally conductive composition according to any one of claims 1 to 6, wherein with respect to a total amount of the thermally conductive composition, a content of the liquid resin is 1.0% by mass or more and 20.0% by mass or less, a content of the thermally conductive powder is 75.0% by mass or more and 98.0% by mass or less, and a content of the acrylic silicone is 0.1% by mass or more and 2.0% by mass or less.

8. The thermally conductive composition according to any one of claims 1 to 7, wherein a content ratio of the liquid resin to the acrylic silicone [liquid resin/acrylic silicone] is 85/15 to 98/2 in terms of a mass ratio.

9. A cured product of the thermally conductive composition according to any one of claims 1 to 8.

## INTERNATIONAL SEARCH REPORT

International application No. **PCT/JP2021/017796**

**A. CLASSIFICATION OF SUBJECT MATTER**

***H01L 23/373***(2006.01)i; ***C08L 83/04***(2006.01)i; ***C08K 3/22***(2006.01)i; ***C08K 3/28***(2006.01)i
FI: C08L83/04; C08K3/28; C08K3/22; H01L23/36 M

According to International Patent Classification (IPC) or to both national classification and IPC

**B. FIELDS SEARCHED**

Minimum documentation searched (classification system followed by classification symbols)

H01L23/373; C08L83/04; C08K3/22; C08K3/28

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2017/002474 A1 (SHOWA DENKO KK) 05 January 2017 (2017-01-05) claims, examples | 1-9 |
| Y | JP 11-209618 A (MATSUSHITA ELECTRIC WORKS, LTD.) 03 August 1999 (1999-08-03) claims, examples, paragraph [0007] | 1-9 |
| Y | JP 2020-73626 A (SHOWA DENKO KK) 14 May 2020 (2020-05-14) claims, examples | 1-9 |
| Y | WO 2017/051738 A1 (SHIN-ETSU CHEMICAL CO., LTD.) 30 March 2017 (2017-03-30) claim 2, example 2, comparative examples 1, 2 | 1-9 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **28 June 2021** | **06 July 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2021/017796**

| Patent document cited in search report | Publication date (day/month/year) | Patent family member(s) | Publication date (day/month/year) |
| --- | --- | --- | --- |
| WO 2017/002474 A1 | 05 January 2017 | US 2018/0179383 A1<br>claims, examples<br>EP 3318605 A1<br>KR 10-2018-0008766 A<br>CN 107849354 A | |
| JP 11-209618 A | 03 August 1999 | (Family: none) | |
| JP 2020-73626 A | 14 May 2020 | (Family: none) | |
| WO 2017/051738 A1 | 30 March 2017 | US 2018/0291249 A1<br>claim 2, example 2, comparativ e examples 1, 2<br>EP 3354707 A1<br>CN 108026437 A<br>KR 10-2018-0061242 A<br>JP 2017-61613 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 11209618 A
- WO 2017002474 A